(19)

Europäisches
Patentamt
European
Patent Office
Office européen
des brevets

(11) **EP 2 521 191 A1**

(12) **EUROPEAN PATENT APPLICATION**

(43) Date of publication:
**07.11.2012   Bulletin 2012/45**

(51) Int Cl.:
*H01L 35/24* (2006.01)

(21) Application number: **11275072.4**

(22) Date of filing: **04.05.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **BAE Systems Plc
London SW1Y 5AD (GB)**

(72) Inventor: **The designation of the inventor has not yet been filed**

(74) Representative: **BAE SYSTEMS plc
Group IP Department
Farnborough Aerospace Centre
Farnborough
Hampshire GU14 6YU (GB)**

(54) **Thermoelectric devices**

(57)    The following invention relates to a thermoelectric device for generating electrical currents exploiting the Seebeck effect, more specifically a structural thermoelectric device which can replace a structural component of a body. According to the invention there is provided a device comprising a conducting polymer, which exploits the Seebeck effect and a reinforcement means. The conducting polymer may be selected from a combination of P-type and N-type conducting polymers.

**Description**

The following invention relates to a thermoelectric device for generating electrical currents exploiting the Seebeck effect, more specifically a structural thermoelectric device which can replace a structural component of a body.

Thermoelectric generators convert heat directly into electrical power through the Seebeck effect. When a temperature gradient is applied across a length of electrically conductive material, there is a net flow of electrons from one end to the other that results in voltage generation. If an electrical load is connected between the ends of the conductor, a constant thermal gradient will result in a constant electrical power output. This mechanism allows useful conversion of thermal energy into electrical energy. The mechanism can be run in reverse i.e. application of electrical energy can be used for cooling, known as the Peltier effect.

For practical thermoelectric devices, semiconductor materials such as bismuth telluride are used as they have a higher Seebeck coefficient (S) than metals. The Seebeck coefficient quantifies the voltage generated for a given temperature difference across the material.

According to a first aspect of the invention there is provided a structural thermoelectric device comprising a first conductor layer, a second conductor layer and located therebetween at least one polymer thermocouple layer comprising at least one conducting polymer and a reinforcement means; in a highly preferred arrangement the polymer thermocouple layer comprises at least one P-type conducting polymer, at least one N-type conducting polymer.

It is possible to dope conducting polymers by adding chemical reactants to oxidise or reduce the system. This means that both P-type and N-type conducting polymers may be fabricated, giving two polymeric materials with opposite Seebeck coefficient, thus providing a larger voltage difference for the same cell dimension.

Commercially available thermoelectric devices are typically fabricated using bismuth telluride (BiTe) semiconductors. One of problems with semiconductors is that they are relatively fragile and so not amenable to large area deposition and are not rugged. In general, a plurality of small thermoelectric modules has to be used in order to achieve large area coverage and the concomitant high levels of power generation. The COTS devices are generally small area, with typical surface areas of $\sim$250mm$^2$ and thicknesses of -4mm.

Therefore the use of conducting polymers as the thermocouple components in a thermoelectric device permits facile fabrication of devices which can be formed to provide a large area device, formed into shaped structures to replace conventional structural panels on a body. Furthermore, devices according to the invention are rugged, robust and hence will provide a thermoelectric device which may withstand harsh environments, in a similar fashion to many composite fibre reinforced polymers. In an alternative arrangement the final polymer thermoelectric device may have additional plasticisers so as to provide a non-rigid, i.e. flexible thermoelectric device. The polymer thermoelectric device according to the invention thus provides a useful replacement to the brittle bismuth telluride structures.

The reinforcement means may be any reinforcement material which provides structural integrity to the cured polymer, such as, for example a plurality of fibres or a porous three dimensional lattice. Preferably the reinforcement means is a rigid porous three dimensional lattice into which said at least one P-type conducting polymer, at least one N-type conducting polymer may be deposed. Preferably the lattice may be formed into the near final shape or final shape of a body. Preferably the reinforcement means does not improve the conduction of heat within the thermocouple layer, i.e. between the first and second conductor layers.

The conducting polymers may be deposited onto the surfaces of the porous lattice, by any known technique, such as spraying, brushing, rollering, printing, dipping etc. The thermoelectric effect is achieved by a layer effect, typically less than 10 millimetre thickness, preferably less than 1 millimetre thickness. If the layer is too thick then the thermoelectric device may have a large mass penalty, reducing its desirability in mass sensitive applications.

Where the internal dimensions of the voids within the lattice approach that of a layer of deposed polymer then the entire void may be filled.

The lattice may comprise a series of elongate voids, a first void comprising an N-type conducting polymer and a second void comprising a P-type conducting polymer, such that an array of N-type and P-type polymers may be provided. To permit an in series electrical connection between the N-type and P-type polymers there may be an electrical connector which electrically connects the N-type conducting polymer in said first void to the P-type conducting polymer in said second void. Preferably the electrical connector attaches to distal end portions of the respective conducting polymers, so as to permit the greatest voltage difference between the respective end portions of each polymer.

The conducting polymers may be selected from polythiophenes(PT) poly acetylenes(PAG), poly anilines(PANI), poly pyrroles(PPY), poly phenylene vinylene(PPV), poly phenylene sulfide(PPS). A particular preferred polymer is Poly (3,4-ethylenedioxythiophene) (PSS:PEDOT).

In a preferred arrangement the polymer thermocouple region may comprise filler materials, such as for example particulates, nano tubes, fibres, to promote cohesion, rigidity, and alter the electrical conductivity of said conducting polymers, and hence the thermocouple polymer. The filler materials must not enhance the thermal conductivity of the polymer, as any conductance of heat from the first conductor layer to the second conductor layer will reduce the output voltage that may be obtained.

In a highly preferred embodiment the conducting polymers may be doped to further broaden the Seebeck coefficient between the selected conducting polymers. The conducting polymers may be chemically altered, such as by oxidation or reduction techniques to create P-type or N-type regions respectively. Alternatively the polymers may be doped with known donor or acceptor moieties to provide respective N-type or P-type conducting polymers.

In a highly preferred embodiment any chemical oxidation or reduction process on the conducting polymers is performed before the final cure reaction.

The conducting polymers will be formed from monomers, oligomers or polymers that have the ability to undergo a cure i.e. polymerisation. Where the uncured conducting polymer material is already a long chain polymer the solidification process may simply be a cross linking reaction to provide the cured conducting polymer which is either deposited on or encapsulates the reinforcement means. It may be desirable to add further non-conducting monomers, oligomers or polymers to regions of the reinforcement means, which are capable of undergoing a cure to increase the structural rigidity. The further non-conducting monomers may be mixed with the conducting polymers and then cured in the form of an admixture or the further non-conducting monomers may be added as a separate layer, which may be cured either together or in separate curing steps.

To facilitate construction of the device, the connector is an electrically conducting material deposited onto the surface of the first and second conductor layers, in a pattern which aligns with the respective N-type and P-type conducting polymers.

In an alternative arrangement the reinforcement means may be selected from a plurality of fibres, such as to provide a fibre reinforced polymer composite material (FRPC). The polymers and reinforcement fibres may be moulded into a final or near final shape, and then cured using standard techniques, so as to provide a body which is capable of undergoing a thermoelectric effect. In a preferred option the fibres are selected from electrically conducting fibres or electrically non-conducting fibres which are coated with an electrically conducting material.

In a further embodiment the reinforcement fibres may additionally be present in the conducting polymers that are deposed on a rigid lattice, such that the reinforcement fibres provide additional strength and rigidity to the final cured device.

The first and second conductor layers and any electrical connectors may be formed from discrete portions of a conducting material and applied to the upper and lower surfaces of the formed polymer thermocouple layer. Alternatively, the first and second conductor layers, and optionally any electrical connectors may be deposited by direct metallic printing, chemical or vapour deposition processes, etching processes. The first and second conductor layers, may be coated with further materials to protect said first and second conductor layers from chemical or physical damage, provided that there is minimal conductive loss. The further materials may be conducting materials such as, for example metallic materials.

In a further arrangement there may be a plurality of thermocouple layers, each comprising arrangements of n- and P-type conducting polymers, arranged between a first and second conductor layer. In a yet further arrangement there may be provided at least two devices according to the invention in a stacked arrangement such that a second conductor layer from a first device is located in thermal contact with a first conductor layer form a second device. The arrangement thereby providing, at least two stacked devices, with a first conductor layer on the first device exposed to one temperature and the second conductor layer on the second device being exposed to a second temperature.

In a further aspect of the invention there is provided an electrical system comprising at least one, preferably a plurality of thermoelectric devices according to invention, wherein the outputs from each n- and P-type conducting polymer are wired such that their voltage outputs are additive i.e. are in series, to provide a large output voltage across the first and second conductor layers.

The thermoelectric device and hence electrical system will generate energy all the time there is a temperature differential between the first and second conductor layers. It may be desirable to store part or all of the electrical energy generated by the thermoelectric effect, for use at a later time. The energy may be stored by any conventional means, such as chemical energy cells, capacitors or more preferably via a polymer composite battery that may be constructed on the first or second conductor layer. The composite battery may preferably be constructed on the conductor layer which provides optimum working conditions for the composite battery, such as for example the conductor layer which is closest to room temperature.

In a further aspect of the invention there is provided a body comprising at least one thermoelectric device according to the invention. The body may be a panel, housing, or moulded entity which may be used in place of an existing non-thermoelectric panel, housing, or moulded entity, such as for example a panel on a vehicle, building, structure may be replaced by a panel formed from a thermoelectric device according to the invention. In a preferred embodiment, the thermoelectric panel is located on an aircraft, where there are large temperature extremes between the outside of the aircraft and the inside of the aircraft.

Typical examples of a thermoelectric housing, may be exhaust or heat exchanger regions, particularly near powertrains on a vehicle, vessels or crafts, such as for example exhausts on combustion engines or turbines.

According to a further aspect of the invention there is provided the use of a structural thermoelectric device according to the invention for generating electrical energy. The ability to generate electricity from a structural panel with a similar weight to an existing panel already in place on a vehicle, vessel or craft, provides a very useful means of generating power, without placing extra burden on the primary power source.

According to a yet further aspect of the invention there is provided the use of a structural polymer thermoelectric device according to the invention for providing a Peltier cooling effect to the first or second conductor layer. Semiconductor based Peltier elements are widely used in cooling, the use of a structural thermoelectric polymer based Peltier element provides an advantage that the actual casing or housing that require cooling, may be made from a structural polymer that has the ability to cool, or indeed heat if so required.

According to a further aspect of the invention there is provided a method of forming a device according to the invention, comprising the steps of providing a rigid porous three dimensional lattice, deposing at least one P-type conducting polymer into a first predetermined region, deposing at least one N-type conducting polymer, into a second predetermined region, deposing an electrical connector between said polymer regions, encapsulating said filled lattice between a first and second conductor layer.

Preferably the lattice has elongate voids, with the P-type and N-type conducting polymers being deposed therein, such that there is a voltage set up along the length of the deposed conducting polymers contained within each elongate void. Preferably the lattice is made from a substantially non-conducting material such that the only electrical pathway for the voltage is to flow in a predetermined pattern, i.e. in series between adjacent N-type and P-type polymers to provide an accumulated voltage. The elongate voids may have any cross-section, preferable one which allows close packing and provides rigidity, such as circular or polygonal cross section, preferably quadrilateral, pentagonal, hexagonal or octagonal.

A yet further method comprises the steps of providing a first conductor layer, deposing at least one P-type conducting polymer, with a reinforcement means provided therein, into a first predetermined region, deposing at least one N-type conducting polymer, with a reinforcement means provided therein, into a second predetermined region, arranged such that there is an electrical junction provided between said N-type and P-type polymers, encapsulating said polymers with said second conductor layer.

In a semi conductor device, two semiconductor materials are used to form a thermocouple, with the two materials having Seebeck coefficients of opposite sign to give greater efficiency and a higher power generation capacity. Thermoelectric modules typically consist of many thermocouples connected electrically in series in order to provide useful voltages.

The voltage generated by a thermoelectric element of this type is given by

$$U=(S_P - S_N)(T_h - T_C) \qquad\qquad (Eq.1)$$

where $S_{P-N}$ is the difference between the two Seebeck coefficients and $T_h - T_c$ is the temperature difference across the module. Other relevant quantifiable characteristics of the devices include the figure of merit, ZT, and the conversion efficiency $\eta$. The figure of merit is given by

$$Z\bar{T} = \frac{\left(S_p - S_n\right)^2 \bar{T}}{\left[\left(\rho_n \kappa_n\right)^{0.5} + \left(\rho_p \kappa_p\right)^{0.5}\right]^2} \qquad (Eq.2)$$

where $\rho_N$ and $\rho_P$ are the respective electrical resistivities and $\kappa_N$ and $\kappa_P$ are the respective thermal conductivities. $\bar{T}$ is the average temperature across the thermocouple. The thermoelectric conversion efficiency is related to the figure of merit by

$$\eta_{max} = \left(\frac{T_h - T_c}{T_h}\right)\frac{\sqrt{1 + Z\overline{T}} - 1}{\sqrt{1 + Z\overline{T}} + \left[\frac{T_c}{T_h}\right]}$$

(Eq.3)

Equations 2 and 3 show that the conversion efficiency is dependent upon a number of factors, including the temperature difference across the device (AT), the Seebeck coefficient, the thermal conductivity, the electrical conductivity and the absolute temperature.

Thermoelectric generators can be used in any situation where there is a suitable temperature differential between the first and second conductor layers, i.e. essentially a hot and cold side. In order to improve the efficiency it is desirable to have a good thermal coupling of the device to the heat source and optionally provide a heat sink to remove heat from the cold side. Mechanical means for mounting the devices are usually needed, and the device type needs to be appropriate for the operational temperature.

An embodiment of the invention will now be described by way of example only and with reference to the accompanying drawings of which:-

Figure 1 shows a side projection of a single thermoelectric cell

Figure 2 is a side projection of a multi element thermoelectric cell

Figure 3 shows a top view of a multi element thermoelectric cell.

Figure 4 shows a side view of a multi element thermoelectric cell with a composite battery located thereon.

Figure 5 shows a side view of a stacked arrangement of multi element thermoelectric cell.

Figures 6a and 6b show side and top views respectively of a conducting polymer coated lattice matrix.

Figures 7a and 7b show electrical connector arrangements of matrix wall coated with a conducting polymer material.

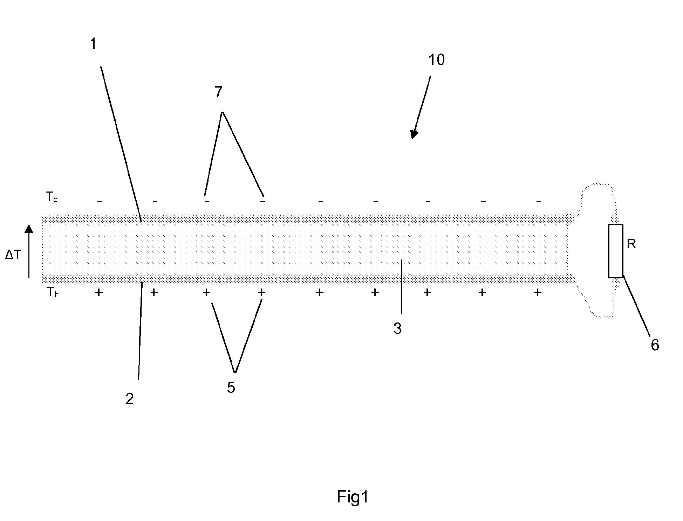

Turning to Figure 1, this shows a simple single layer fibre reinforced thermoelectric polymer device 10, with a first conductor layer 1, and second conductor layer 2 applied to the top and bottom of the thermocouple composite later 3. The thermocouple layer may contain one type of conducting polymer, however this will limit the voltage that is achieved between the first and second conductor layers 1, 2.

When a temperature differential is applied across the thermocouple 3, the thermoelectric effect will result in a net drift of electrons 5 from the hot side $T_h$ to the cold side $T_c$, 7 nominally shown as the first conductor layer 1, of the composite thus generating a voltage. This would enable current flow to be generated through a load resistance $R_L$ 6.

The construction of the device 10 is simple and may use current FRPC lay up and curing technology, as the polymers are very durable and rugged any such device 10 is therefore amenable to large area fabrication with good structural properties. However, while the current that is drawn may be reasonable if the composite is fabricated over a large area, the voltage produced by this structure is unlikely to exceed a few tens of millivolts as it is in effect a single thermoelectric element. A DC-DC converter (not shown) may be used to step up the voltage if required. The first and second conductor layers 1, 2, may be formed by depositing a suitable conducting material onto the upper and lower surfaces of the thermocouple composite layer 3, and could be protected by the addition of further protective layers.

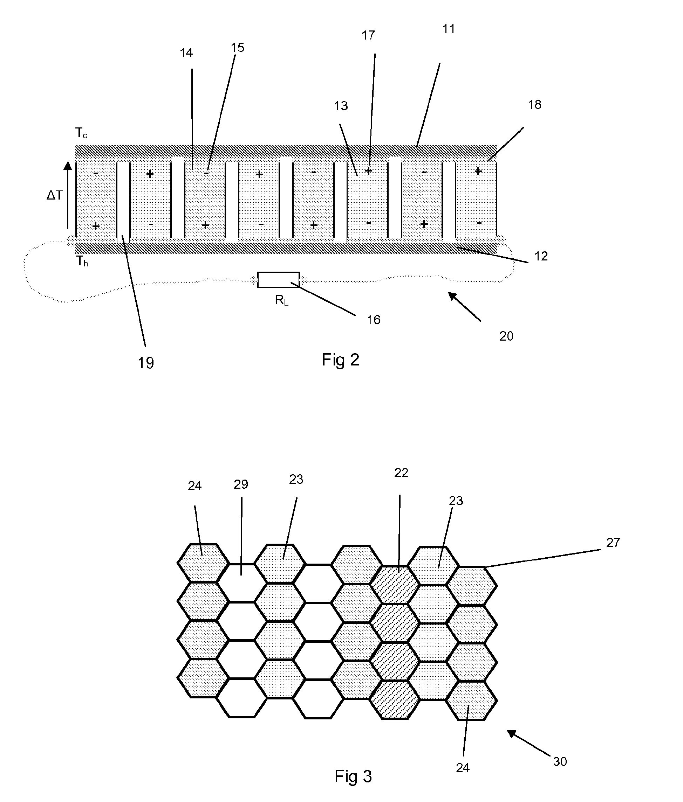

Figure 2 shows side projection of a multi element thermoelectric cell 20. To produce higher voltages from a composite structure the use of P-type 14 and N-type 13 conducting polymers are arranged in cells, as described earlier the doping is performed by using chemical reactants to oxidise or reduce the system, giving two polymeric materials with opposite Seebeck coefficient.

The cell 20 has a first conductor layer 11 nominally shown here as the cold layer $T_c$, and a second conductor layer 12, nominally the hot layer $T_h$. In the above arrangement, the N-type material 14, sets up a negative voltage 15 at the cold surface (first conductor layer) 11. Whereas, the P-type material 13, sets up a positive voltage 17 at the cold surface( first conductor layer)11. the n type and P-type materials are electrically isolated from each other along their longest dimension by a barrier 19, which may be a void or dielectric material. Therefore the use of an electrical connector 18 located between the N-type 14 and P-type 13 at the end portion means that the voltage that can be generated will be increased to useful levels by the summation of the voltages produced across each element 13 and 14. There may be further encapsulation by carbon fibre skins applied top and bottom on the first layer 11 and second layer 12 to provide further stiffness. The conductor layers

Figure 3 shows a top view of one arrangement of a filled lattice 30 with hexagonal elongate voids. One row of elongate voids are filled in part with. There is a row 29 of empty, non-filled elongate voids, separating a row filled elongate voids containing P-type conducting polymer 23. Alternatively the row between the N-type and P-type material may be filed with a further polymer 22, so as to provide further rigidity and structural stiffness to the final cured device. The lattice material 27, is a non-conducting material, so in a further arrangement the P-type conducting polymer 23 and N-type conducting polymer 24 may only be separated by the lattice. The end portion of 23 and 24 will be electrically connected together in a manner as shown in fig 2.

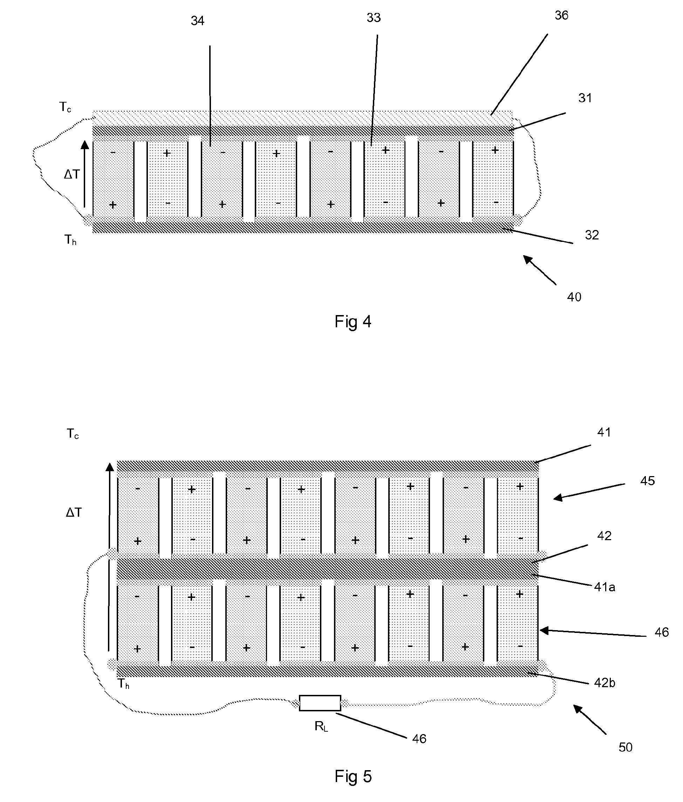

Figure 4 shows a side view of a multi element thermoelectric cell 40 with a composite battery 36 located thereon. The battery 36 is located on the first conductor layer 31, which in this example is the nominally cold surface $T_c$. It is desirable that the battery is formed on the most appropriate surface. If the cold surface is excessively cold or the cold layer forms part of an exterior surface on a vehicle vessel or craft, then it may be desirable to locate the battery on the second conductor layer 32. In a similar arrangement to that of figure 2, to produce higher voltages from a composite structure the use of P-type 34 and N-type 33 conducting polymers are arranged in cells, as described earlier the doping is performed by using chemical reactants to oxidise or reduce the system, giving two polymeric materials with opposite Seebeck coefficient.

Figure 5 shows a side view of a stacked arrangement 50 of two multi element thermoelectric cells 45 and 46. The first conductor layer 41 of the top most cells 45, forms the outer cold facing surface $T_c$. The second conductor layer 42 of the top most cell 45 is in thermal contact with the first conductor layer 41 a of the lower cell 46, and the second conductor layer 42b of the lower cell 46, forms the outer hot facing surface $T_h$.

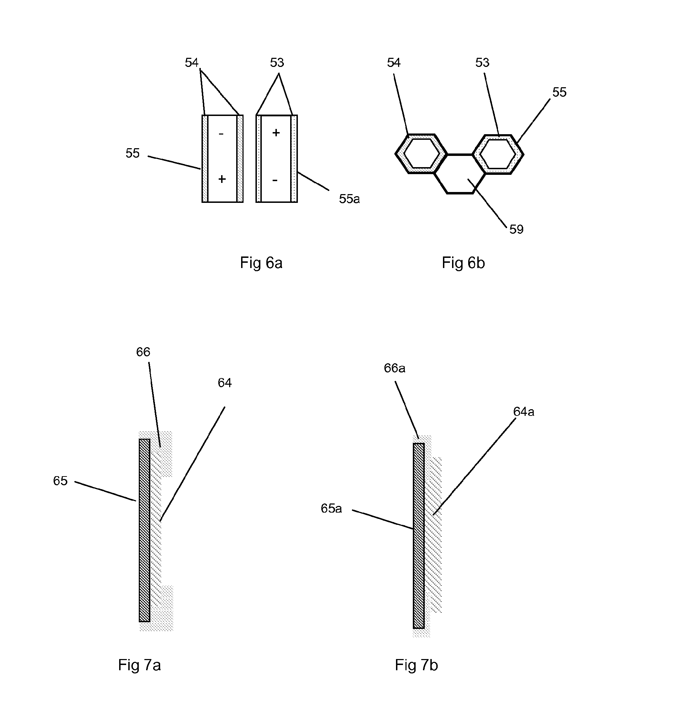

Figure 6a shows a close up of the voids in figure 2, wall 55 of the void has a surface coating 54 of a P-type conducting polymer. In a similar fashion wall 55a has a surface coating 53 of an N-type conducting polymer. Figure 6b shows a top view of the hexagonal cross section structure in figure 3, where the wall 55 of the honeycomb like structure has surface coatings of P-type 54 and N-type 53 conducting polymers. The specific arrangement shows the two cells being separated by an empty non-coated cell 59.

Figure 7a shows one arrangement of a wall 65 of a void within a matrix (as shown in Figure 6a) which has a surface coating of a conducting polymer 64 deposed thereon. The conducting polymer 64 may be electrically connected by a subsequent deposition of a conducting element 66, such as a conductive ink or paste. The element 66 may then be further connected to electrical connectors (18, as shown in figure 2), which connect the P-type and N-type columns in series.

Figure 7b shows an alternative arrangement where the conducting element 66a is deposed first on the wall 65a of the void, and then the conducting polymer 64a is deposited on top of said conducting element 66a.

## Claims

1. A structural thermoelectric device comprising a first conductor layer, a second conductor layer and located therebetween a polymer thermocouple layer comprising at least one conducting polymer and a reinforcement means

2. A device according to claim 1 wherein the polymer thermocouple layer comprises at least one P-type conducting polymer, at least one N-type conducting polymer.

3. A device according to claim 1 or claim 2, wherein the reinforcement means is a rigid porous three dimensional lattice, into which said at least one P-type conducting polymer, at least one N-type conducting polymer may be deposed.

4. A device according to claim 3, wherein the lattice comprises a series of elongate voids, a first void comprising an N-type conducting polymer and a second void comprising a P-type conducting polymer.

5. A device according to any one of claims 2 to 4 wherein there is a connector which electrically connects the N-type conducting polymer to the P-type conducting polymer.

6. A device according to claim 5, wherein the connector is an electrically conducting material deposited onto the surface of the first and second conductor layers.

7. A device according to claim 1 or claim 2, wherein the reinforcement means is a plurality of fibres.

8. A device according to claim 7, wherein the fibres are electrically conducting fibres.

9. A device according to any one of the preceding claims wherein the polymer thermocouple layer comprises a filler material.

10. An electrical system comprising a plurality of thermoelectric devices according to any one of the preceding claims wherein the outputs are wired such that they are in series, to provide a large output voltage across the first and second conductor layers.

11. A system according to claim 10, wherein a polymer composite battery is constructed on the first or second conductor layer.

12. A body comprising at least one thermoelectric device according to any one of claims 1 to 10.

13. The use of a structural thermoelectric device according to any one of claims 1 to 10 for generating electrical current, or for providing a Peltier cooling effect to the first or second conductor layer.

14. A method of forming a device according to any one of claims 1 to 6, comprising the steps of providing a rigid porous three dimensional lattice, deposing at least one P-type conducting polymer into a first predetermined region, deposing at least one N-type conducting polymer, into a second predetermined region, deposing an electrical connector between said polymer regions, encapsulating said filled lattice between a first and second conductor layers, and curing the polymers.

15. A method of forming a device according to any one of claims 7 or 8, comprising the steps of providing a first conductor layer, deposing at least one P-type conducting polymer, with a reinforcement means provided therein, into a first predetermined region, deposing at least one N-type conducting polymer, with a reinforcement means provided therein, into a second predetermined region, arranged such that there is an electrical junction provided between said N-type and P-type polymers, encapsulating said polymers with said second conductor layer, and curing the polymers.

Fig1

Fig 2

Fig 3

Fig 4

Fig 5

Fig 6a

Fig 6b

Fig 7a

Fig 7b

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | DE 10 2010 031829 A1 (NOVALED AG [DE])<br>3 February 2011 (2011-02-03)<br>* paragraph [0033] - paragraph [0046];<br>figures 1-5 * | 1-6,10,<br>12-14<br>11,15<br>7-9 | INV.<br>H01L35/24 |
| X<br><br>Y<br>A | WO 2009/029393 A2 (BATTELLE MEMORIAL<br>INSTITUTE [US]; LAUDO JOHN S [US])<br>5 March 2009 (2009-03-05)<br>* page 7, line 2 - page 12, line 6;<br>figures 1-2 * | 1,2,5-9,<br>12,13<br><br>11,15<br>10 | |
| X<br><br>A | EP 1 818 992 A1 (TNO [NL])<br>15 August 2007 (2007-08-15)<br>* paragraph [0009] - paragraph [0014];<br>figures 1-3 * | 1,2,5,<br>10,12,13<br>3,4,6-9,<br>11,14,15 | |
| Y<br><br><br>A | WO 2009/063805 A1 (MURATA MANUFACTURING CO<br>[JP]; NAKAMURA TAKANORI [JP]; YAMADA<br>KAZUHIRO) 22 May 2009 (2009-05-22)<br>* abstract * | 11<br><br><br>1-10,<br>12-15 | |
| A | WO 2008/073668 A2 (GEN ELECTRIC [US];<br>SHARIFI FRED [US]; SEKER FAZILA [US])<br>19 June 2008 (2008-06-19)<br>* paragraph [0044]; figure 4 * | 1-15 | TECHNICAL FIELDS<br>SEARCHED (IPC)<br><br>H01L |
| A | US 2007/221264 A1 (SHUTOH NAOKI [JP] ET<br>AL) 27 September 2007 (2007-09-27)<br>* paragraph [0042] - paragraph [0051];<br>figure 3 * | 1-15 | |
| A | EP 1 030 379 A1 (NGK INSULATORS LTD [JP])<br>23 August 2000 (2000-08-23)<br>* abstract; figures 1-3 * | 1-15 | |

The present search report has been drawn up for all claims

| Place of search | Date of completion of the search | Examiner |
|---|---|---|
| The Hague | 6 October 2011 | Kirkwood, Jonathan |

EPO FORM 1503 03.82 (P04C01)

**ANNEX TO THE EUROPEAN SEARCH REPORT
ON EUROPEAN PATENT APPLICATION NO.**

EP 11 27 5072

This annex lists the patent family members relating to the patent documents cited in the above-mentioned European search report.
The members are as contained in the European Patent Office EDP file on
The European Patent Office is in no way liable for these particulars which are merely given for the purpose of information.

06-10-2011

| Patent document cited in search report | Publication date | Patent family member(s) | | Publication date |
|---|---|---|---|---|
| DE 102010031829 A1 | 03-02-2011 | NONE | | |
| WO 2009029393 A2 | 05-03-2009 | EP | 2183796 A2 | 12-05-2010 |
| | | US | 2011120516 A1 | 26-05-2011 |
| EP 1818992 A1 | 15-08-2007 | AU | 2007212821 A1 | 16-08-2007 |
| | | CA | 2641603 A1 | 16-08-2007 |
| | | EP | 1987550 A1 | 05-11-2008 |
| | | JP | 2009526151 A | 16-07-2009 |
| | | WO | 2007091890 A1 | 16-08-2007 |
| WO 2009063805 A1 | 22-05-2009 | NONE | | |
| WO 2008073668 A2 | 19-06-2008 | US | 2008135081 A1 | 12-06-2008 |
| US 2007221264 A1 | 27-09-2007 | CN | 101043064 A | 26-09-2007 |
| | | JP | 4266228 B2 | 20-05-2009 |
| | | JP | 2007258571 A | 04-10-2007 |
| EP 1030379 A1 | 23-08-2000 | DE | 60029855 T2 | 15-02-2007 |
| | | JP | 2000236117 A | 29-08-2000 |
| | | US | 6288322 B1 | 11-09-2001 |

EPO FORM P0459

For more details about this annex : see Official Journal of the European Patent Office, No. 12/82